# FASCICULE DE BREVET EUROPEEN

(11) **EP 3 072 149 B1**
(45) Date de publication et mention de la délivrance du brevet: **10.01.2018**
(21) Numéro de dépôt: 14814932.1
(22) Date de dépôt: 19.11.2014
(51) Int. Cl.: H01L 21/311, H01L 21/8238

(54) **PROCÉDÉ DE GRAVURE SÉLECTIVE D'UN MASQUE DISPOSÉ SUR UN SUBSTRAT SILICIÉ**
VERFAHREN ZUR SELEKTIVEN ÄTZUNG EINER AUF EINEM SILICIUMSUBSTRAT ABGELAGERTEN MASKE
METHOD FOR THE SELECTIVE ETCHING OF A MASK DISPOSED ON A SILICON SUBSTRATE

(30) Priorité: 20.11.2013 FR 1361394
(43) Date de publication de la demande: 28.09.2016
(73) Titulaire: Commissariat à l'Énergie Atomique et aux Énergies Alternatives, 75015 Paris (FR)
(72) Inventeur: POSSEME, Nicolas, 38360 Sassenage (FR)
(74) Mandataire: Delorme, Nicolas
(86) Numéro de dépôt international: PCT/FR2014/052965
(87) Numéro de publication internationale: WO 2015/075380

(56) Documents cités:
- US-A1- 2007 243 700

## Description

La présente invention concerne un procédé de gravure sélective d'un masque en un matériau carboné déposé sur un substrat silicié. Lors de la fabrication des circuits intégrés sur un substrat par exemple de silicium, une étape d'implantation d'espèces ioniques est nécessaire pour doper localement le substrat et permettre la réalisation de transistors N ou P. Au préalable de cette implantation, les zones du substrat ne devant pas être implantées sont protégées par la formation d'un masque généralement formé de résine. Après implantation de type N ou P en vue de la réalisation de transistors, le sommet de la résine protégeant les zones non implantées se trouve implanté par la même occasion. Afin de finaliser la fabrication des dispositifs, il est ensuite nécessaire de retirer le masque. Or, l'étape de retrait traditionnelle d'une résine par voie sèche ou voie humide n'est pas efficace lorsque la résine a été implantée au préalable. Le masque implanté forme en effet une croûte en surface qui est très difficile à retirer de façon précise et dans des conditions n'endommageant pas les régions du substrat non recouvertes par le masque. Il est alors connu de procéder au retrait du masque en deux étapes. La première étape consiste en un retrait de la croute en surface puis la deuxième étape consiste en un retrait de la résine non implantée sous-jacente. Toutefois, la première étape nécessite l'utilisation d'une chimie de gravure agressive pouvant endommager et consommer le silicium du substrat notamment au niveau de la source et du drain implantés, dégradant ainsi les performances des dispositifs.

Une solution décrite par Kurt K. Christenson et al. dans la publication 'All Wet stripping Of Implanted Photoresist', 8th International Symposium on Ultra Clean Processing of Semiconductor Surfaces UCPSS, 2006, utilise une solution chimique nommée Piranha comprenant un mélange de H₂SO₄ et de H₂O₂. Les inconvénients de cette méthode résident en ce que cette solution chimique montre une réactivité relativement lente vis à vis de la résine implantée et en ce que sa réactivité face à l'oxyde SiO₂ suggère un risque d'endommagement important d'un substrat en silicium.

Une alternative à cette méthode consiste à effectuer une gravure par voie sèche comprenant une étape de gravure par plasma de CF₄/O₂ suivie d'une étape de gravure par plasma N₂/O₂ généré par micro onde à température élevée. La encore, l'endommagement du substrat de silicium non recouvert par le masque lors de la première gravure est tel qu'il n'est pas possible de précisément contrôler l'endommagement des zones de silicium dopées N et P.

Une autre alternative est décrite dans le document US 2007/243700 A1. La présente invention vise à pallier ces inconvénients et propose à cet effet un procédé de gravure sélective d'un masque en matériau carboné disposé sur un substrat silicié, caractérisé en ce qu'il comprend les étapes consistant à :
a) Fournir un substrat silicié comportant une première portion recouverte par le masque en matériau carboné et une seconde portion dopée, le masque comportant en surface une couche de surface comprenant des espèces ioniques implantées et une couche sous-jacente libre d'espèces ioniques implantées,
b) Exposer la couche de surface et la seconde portion à un plasma de SiCl₄ et de Cl₂ de sorte à déposer une couche de chlorure de silicium SiClx sur la seconde portion et à graver la couche de surface,
c) Graver la couche sous-jacente de sorte à exposer la première portion, et
d) Graver la couche de chlorure de silicium SiClx, de sorte à exposer la seconde portion.

Ce procédé permet ainsi de retirer sélectivement le masque de façon contrôlée, sans endommager le substrat silicié, notamment ses zones dopées. En effet, la gravure de la couche de surface implantée du masque est réalisée en même temps que la couche de chlorure de silicium SiClx est déposée sur le substrat silicié, grâce notamment à un plasma combinant du SiCl4 et du Cl2. Cette couche de chlorure de silicium SiClx assure la fonction de couche de protection du substrat silicié. Une fois la couche de surface implantée retirée, le retrait de la couche sous jacente du masque peut être effectué par une gravure qui attaque plus rapidement la couche sous-jacente que la couche de chlorure de silicium SiClx protégeant le substrat silicié. Il est alors possible de retirer la totalité du masque avant que la couche de chlorure de silicium SiClx de protection ne disparaisse. Ensuite, cette couche de chlorure de silicium SiClx est retirée sélectivement par rapport au substrat silicié de sorte à pouvoir finaliser la fabrication des composants.

Il est entendu dans le présent document que la première portion du substrat n'est pas nécessairement continue, mais qu'elle peut être discontinue et répartie sur l'ensemble du substrat. Il en est de même pour la seconde portion du substrat.

Par ailleurs, la seconde portion du substrat silicié peut comprendre des précurseurs de fabrication de dispositifs électroniques.

Il est également entendu que l'étape b) dans le présent document permet de retirer au moins partiellement la couche de surface.

Selon une possibilité, l'étape b) est réalisée à une température comprise entre 20 et 120°C et de préférence aux alentours de 60°C.

Typiquement, le masque en matériau carboné est constitué d'une résine carbonée, telle qu'une résine époxy, ou du SoC (acronyme anglais Spin on Carbon) et le substrat silicié est constitué de silicium, de nitrure de silicium, d'oxyde de silicium, de SiC, de SiGe ou tout autre matériau comportant du silicium. Un tel masque est en effet peu coûteux. Il est par ailleurs facile à former par dépôt d'une couche en matériau carboné, puis par formation de motifs exposant la seconde portion du substrat silicié permettant un dopage local par implantation d'espèces ioniques.

Selon une possibilité, l'étape b) consiste à graver partiellement la couche de surface et le procédé comprend entre l'étape b) et l'étape c) une étape b1) consistant à graver par plasma fluoré la portion de la couche de surface résiduelle, notamment par plasma de CF₄ ou de SF₆. Autrement dit, l'étape b) comprend une étape b1) réalisée à la suite de la gravure partielle de la couche de surface. La couche sous jacente du masque est alors exposée en fin d'étape b1) et l'étape c) peut être réalisée.

En effet, une fois obtenue par dépôt à l'étape b) l'épaisseur de la couche de chlorure de silicium SiClx nécessaire pour protéger le substrat silicié lors de toutes les étapes ultérieures de gravure du masque, il est possible de modifier les conditions de gravure de la couche de surface. Le plasma fluoré permet notamment d'accélérer la gravure de la couche de surface implantée tout en amorçant le retrait d'une partie de la couche de chlorure de silicium SiClx avec toutefois une grande sélectivité de gravure.

Selon une possibilité, la gravure par plasma fluoré de l'étape b1) comprend en outre de l'oxygène. Il est noté que dans ces conditions d'exposition à l'oxygène, le chlorure de silicium SiClx s'oxyde spontanément, au moins sur quelques nanomètres de la couche de protection, notamment en SiOzCly avec y < x. Après le retrait total de la couche de surface, l'étape c) de gravure de la couche sous jacente peut alors être réalisée.

Avantageusement, le plasma utilisé à l'étape b) est obtenu par un débit de SiCl₄ compris entre 20 à 200 cm³/min, de préférence compris entre 80cm³/min et 120 cm³/min et un débit de Cl₂ inférieur à 20 cm³/min, de préférence compris entre 5 et 15 cm³/min. Ces conditions permettent en effet la gravure de la couche de surface tout en favorisant le dépôt de la couche de chlorure de silicium SiClx et évitant une gravure du silicium du substrat silicié.

Lorsque le substrat silicié est en silicium, le masque en résine carbonée et que les espèces ioniques dérivées de l'arsenic sont implantées à 60 nm de profondeur dans la résine, le débit de SiCl₄ est de préférence d'environ 95cm³/min et le débit de Cl₂ est de préférence d'environ 10 cm³/min.

De préférence, le plasma utilisé à l'étape b) est obtenu dans un réacteur de gravure paramétré pour fournir une puissance inférieure à 300 W. Au-delà, le dépôt de la couche de chlorure de silicium a également lieu sur la couche de surface du masque.

De préférence encore et dans le cas d'une résine carbonée, la puissance utilisée de la source du réacteur de gravure est inférieure à environ 250 W.

De façon optimale, l'étape b) est réalisée dans un réacteur de gravure paramétré pour appliquer au substrat silicié une tension de polarisation comprise entre 100 et 200V et de préférence une tension de polarisation comprise entre 120V et 150V. Ces conditions contrôlent de façon optimisée l'énergie des ions de sorte à favoriser le dépôt de la couche de chlorure de silicium et à accélérer la gravure de la couche de surface.

De préférence encore pour l'exemple mentionné ci dessus, la tension de polarisation est d'environ 130V.

Typiquement, le réacteur de gravure est paramétré pour appliquer au substrat silicié une tension de polarisation pulsée avec une fréquence comprise entre 100Hz et 5kHz et un rapport cyclique compris entre 20 et 90%. Ces conditions améliorent la sélectivité de la gravure par comparaison avec l'application d'une tension de polarisation continue.

Selon une disposition, l'étape c) est réalisée par plasma d'un mélange d'azote et d'hydrogène, notamment par plasma généré avec une fréquence choisie parmi les micro-ondes. Ces conditions de gravure permettent une très bonne sélectivité de gravure de la couche sous-jacente vis à vis de la couche de chlorure de silicium déposée. Il est par ailleurs observé que lors du déplacement du substrat dans le réacteur à micro-onde et que le substrat est exposé à l'air, l'oxygène de l'air oxyde spontanément le chlorure de silicium, notamment sur une faible épaisseur de la couche.

Selon une possibilité, l'étape d) est réalisée par voie humide, notamment avec une solution diluée d'HF. Cette gravure permet de retirer efficacement le chlorure de silicium sans endommager ni consommer le substrat silicié. Il est par ailleurs probable que cette étape oxyde spontanément une partie du chlorure de silicium qui est alors gravé tout comme le chlorure de silicium non oxydé.

Avantageusement, les étapes b), c) et/ou b1) sont réalisées dans la même enceinte d'un réacteur de gravure, le réacteur de gravure étant du type réacteur de gravure plasma à couplage capacitif ou à couplage inductif. Il n'est donc pas nécessaire de déplacer le substrat d'un réacteur à un autre pour réaliser le retrait sélectif du masque, ce qui limite avantageusement les risques d'endommagement du substrat.

Selon une disposition, l'étape a) comprend au préalable une étape a1) consistant à former le masque sur la première portion du substrat silicié puis une étape a2) consistant à implanter des espèces ioniques dans la seconde portion du substrat silicié et dans le masque de sorte à former la couche de surface.

L'étape d'implantation des espèces ioniques permettent de doper la seconde portion du substrat n'ayant pas été recouverte par le masque, de sorte notamment à y former des transistors N et P. Le masque recouvrant la première portion reçoit les espèces ioniques implantées à la place de la première portion du substrat qui reste libre espèces ioniques implantées. Les propriétés électriques de la première portion du substrat restent alors inchangées.

D'autres aspects, buts et avantages de la présente invention apparaîtront mieux à la lecture de la description suivante d'un mode de réalisation de celle-ci, donnée à titre d'exemple non limitatif et faite en référence aux dessins annexés. Les figures ne respectent pas nécessairement l'échelle de tous les éléments représentés de sorte à améliorer leur lisibilité. Par ailleurs, le mode de réalisation est illustré en relation avec la fabrication de transistors. Dans la suite de la description, par souci de simplification, des éléments identiques, similaires ou équivalents des différentes formes de réalisation portent les mêmes références numériques.
La figure 1 illustre une vue en coupe schématique d'un substrat recouvert d'un masque selon l'étape a) du procédé selon un mode de réalisation de l'invention.
La figure 2 illustre une vue en coupe schématique du substrat au cours de l'étape b) de gravure du procédé selon un mode de réalisation de l'invention.
La figure 3 illustre une vue en coupe schématique du substrat en fin de réalisation de l'étape b1) de gravure du procédé selon un mode de réalisation de l'invention.
La figure 4 illustre une vue en coupe schématique du substrat en fin de réalisation de l'étape c) de gravure du procédé selon un mode de réalisation de l'invention.
La figure 5 illustre une vue en coupe schématique du substrat en fin de réalisation de l'étape d) de gravure du procédé selon un mode de réalisation de l'invention.

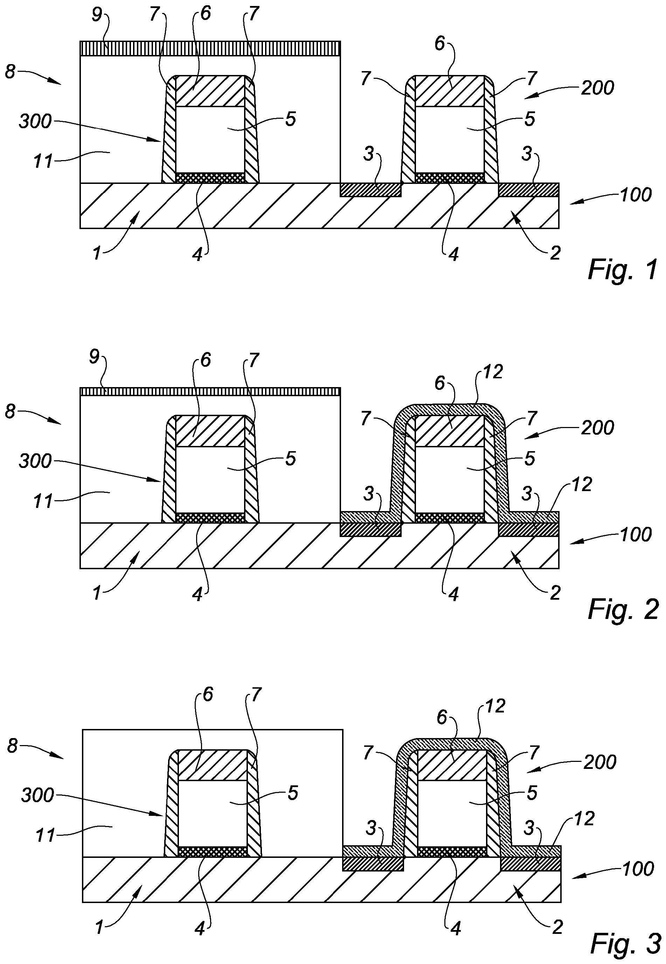

Comme illustré à la figure 1 (étape a), le substrat silicié 100 présente une première portion 1 recouverte d'un masque 8 et une seconde portion 2 dopée par des espèces ioniques implantées. Le substrat silicié 100 est un substrat de silicium mais peut être constitué de tout matériau à base de silicium, tel que du nitrure de silicium, de l'oxyde de silicium, du SiC ou du SiGe. Les espèces ioniques proviennent de l'arsenic, bien que toute nature d'espèces ioniques adaptées au dopage du substrat silicié 100 peut être utilisée. Elles ont été implantées par exemple avec une dose de 5^{E}15 at/cm2 avec une énergie de 12keV et selon un angle de 20° de sorte à implanter les espèces ioniques sous la grille. La seconde portion 2 du substrat silicié 100 représentée comprend à titre d'exemple un premier transistor 200 de type MOS pour lesquels les zones dopées 3 forment la source et le drain. Le transistor 200 comprend également un oxyde de grille 4, une grille 5 protégée par un masque dur 6 et des espaceurs latéraux 7, isolant la source et le drain 3. A titre d'exemple également et sans départir du cadre de l'invention, la première portion 1 du substrat 100 comprend un second transistor 300 protégé par le masque 8 pour ne pas être soumis à l'implantation d'espèces ioniques. Ce second transistor comprend un oxyde de grille 4, une grille 5 protégée par un masque dur 6 et des espaceurs latéraux 7. Il est entendu dans le présent document que tout autre dispositif électronique dont la fabrication nécessite l'implantation d'espèces ioniques dans le substrat silicié 100 peut être prévu à la place du premier transistor 200 MOS. De même, tout autre dispositif devant être protégé de l'implantation peut être prévu à la place du second transistor 300.

Le substrat silicié 100 a notamment été obtenu après formation d'un masque 8 sur la première portion 1 (étape a1) et dans lequel une implantation d'espèces ioniques dopantes (étape a2) a été réalisée. Ce masque 8 selon l'invention est constitué d'un matériau carboné, tel qu'une résine carbonée, mais tout autre matériau adapté pour servir de masque vis-à-vis d'une implantation d'espèces ioniques peut être utilisé. Au niveau de la première portion 1, les espèces ioniques sont implantées dans le masque 8 formant ainsi une couche de surface 9 contenant les espèces ioniques. Cette couche de surface 9 délimite une couche sous-jacente 11 plus profonde dans le masque 8 et qui ne contient pas ou très peu d'espèces ioniques implantées. Au niveau de la seconde portion 2 du substrat silicié 100, les espèces ioniques sont implantées dans le substrat silicié 100. Elles permettent d'obtenir un dopage localisé dans le substrat permettant de former des fonctionnalités pour des composants ultérieurs. Dans l'exemple illustré, ce dopage forme la source et le drain 3 du premier transistor 200.

Comme illustré à la figure 2 (étape b), la couche de surface 9 du masque 8 est partiellement gravée par plasma d'un mélange de SiCl₄ et de Cl₂. Dans le même temps, une couche de chlorure de silicium 12 (SiClx) est déposée sur la seconde portion 2 du substrat silicié 100. Dans l'exemple particulier comportant un transistor 200, les espaceurs 7 et le masque dur 6 sont également recouvert de la couche de chlorure de silicium 12. Les conditions de l'exposition au plasma peuvent varier selon les matériaux et épaisseurs considérées. Le débit de SiCl₄ peut être réglé entre 20 et 200 cm³/min et de préférence entre 80 à 120 cm³/min. Le débit de Cl₂ est réglé à une valeur inférieure à 20 cm³/min et de préférence entre 5 à 15 cm³/min. Dans le cas particulier d'un substrat de silicium et d'une résine carbonée tel que décrit ci dessus, le débit de SiCl₄ et de Cl₂ sont respectivement réglés à environ 95 cm³/min et à environ 10 cm³/min. La durée de cette étape peut varier entre environ 15 secondes et 2 min. Par exemple, pour une durée d'application du plasma sur 30 secondes, l'épaisseur de la couche de chlorure de silicium 12 SiClx déposée est d'environ 5 mm, cette épaisseur augmente linéairement en fonction de la durée. De la même façon, l'épaisseur de la couche de surface 9 gravée augmente linéairement avec le temps. Elle est par exemple gravée sur 3 nanomètres en 30 secondes.

Par ailleurs, le réacteur de gravure à plasma du type à couplage inductif ou de couplage capacitif, présente une source réglée pour fonctionner à une puissance inférieure à 300W, et de préférence à une puissance d'environ 250 W. Le générateur du réacteur est également réglé pour produire une tension de polarisation (bias voltage) dans une gamme comprise entre 100 et 200V et de préférence comprise entre 120 et 150V et de préférence dans le cas particulier décrit ci-dessus une tension d'environ 130V.

La tension de polarisation utilisée est continue ou bien pulsée, ce qui permet dans ce dernier cas d'améliorer les résultats obtenus et de limiter l'endommagement du substrat silicié 100.

Selon une possibilité, la gravure par plasma chloré selon l'étape b) est mise en oeuvre jusqu'au retrait total de la couche de surface 9 implantée.

Selon une autre possibilité, la gravure de la couche de surface 9 est réalisée en deux temps: une fois que l'épaisseur de la couche de chlorure de silicium 12 SiClx déposée à l'étape b) est suffisante pour protéger les couches sous jacentes, il reste une portion de couche de surface 9 résiduelle. Le plasma de gravure est alors modifié pour accélérer le retrait de la couche de surface 9 (figure 3 - étape b1). Un plasma fluoré est alors utilisé sans changer d'enceinte du réacteur de gravure. Le plasma fluoré appliqué peut être choisi à base de CF₄ ou de SF₆/Ar. Par exemple, le plasma fluoré peut être obtenu avec un débit de 50 cm³/min de CF₄ pour un débit de 500 cm³/min d'Ar une pression de 10 mtorr et une puissance de 1200 W. Dans ces conditions et selon l'exemple précité, la vitesse de gravure de la couche de chlorure de silicium 12 SiClx est d'environ 38 nm/min et celle du masque 8 est d'environ 150 nm/min.

Dans le cas d'un débit de 35 cm³/min de SF₆ pour un débit de 500 cm³/min d'Ar et avec une pression de 10 mtorr et une puissance de 1200 W la vitesse de gravure de la couche chlorure de silicium 12 SiClx est d'environ 56 nm/min et celle du masque 8 est d'environ 120 nm/min.

Pour accélérer la vitesse de gravure de la portion de couche de surface 9 résiduelle (étape b1) et augmenter la sélectivité de gravure vis-à-vis du chlorure de silicium, de l'oxygène peut être ajouté aux chimies précédentes par exemple avec un débit de 200 cm³/min. Cet oxygène oxyde spontanément au moins en partie la couche de chlorure de silicium 12 SiClx en formant notamment du SiOzCly avec y <x. Dans ces conditions, avec un plasma à base de SF₆/Ar, la vitesse de gravure de la couche de chlorure de silicium 12 oxydé ou non est d'environ 33 nm/min et celle du masque 8 est d'environ 407 nm/min. Avec un plasma à base de CF₄/Ar et l'oxygène, la vitesse de gravure de la couche de chlorure de silicium 12 oxydé ou non est réduite à environ 17 nm/min et la gravure du masque 8 atteint environ 560 nm/min (non illustré).

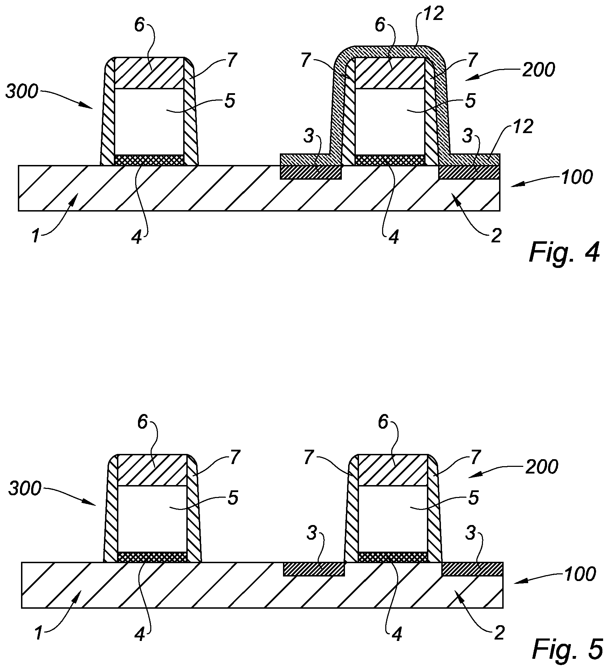

Comme illustré à la figure 4, une gravure selon l'étape c) du procédé est ensuite mise en oeuvre de sorte à retirer la couche sous-jacente 11 correspondant à la portion de masque 8 non implanté. Cette gravure est avantageusement mise en oeuvre dans la même enceinte de gravure que celle utilisée lors de la gravure selon l'étape b) et l'étape b1), lorsque cette dernière est mise en oeuvre. La couche sous-jacente 11 est alors soumise à un plasma de N₂/H₂ généré par micro-onde. Cette chimie présente une très grande sélectivité de gravure pour la couche sous-jacente 11 vis-à-vis de la couche de chlorure de silicium 12, oxydée ou non, sur la seconde portion 2. Cette exposition permet le retrait total de la couche sous-jacente 11 tandis que la couche de chlorure de silicium 12 est partiellement gravée. Typiquement, lorsque la tension de polarisation utilisée est continue, la couche de chlorure de silicium 12 est gravée sur 1 nm en 15 secondes de traitement plasma. Par contre, en utilisant une tension de polarisation pulsée avec une fréquence de 500Hz et un rapport cyclique (ou « duty cycle ») de 50% la couche de chlorure de silicium 12 oxydée ou non n'est pas gravée alors que la couche sous jacente 11 l'est totalement. Typiquement, la tension de polarisation pulsée peut présenter une fréquence comprise entre 100Hz et 5kHz pour un rapport cyclique compris entre 20 et 90% de sorte à améliorer la sélectivité de la gravure.

Enfin, comme illustré à la figure 5, la couche de chlorure de silicium 12 est gravée par voie humide en présence d'une solution diluée d'acide HF. Si le chlorure de silicium n'a pas été au moins partiellement oxydé lors d'un changement de réacteur ou d'un plasma fluoré comprenant de l'oxygène selon l'étape b1), il est oxydé lors de la remise à l'air du substrat pour effectuer la gravure par solution aqueuse de HF. Selon l'épaisseur résiduelle de la couche de chlorure de silicium 12 et le temps de gravure souhaité, la solution d'acide HF est choisie avec une concentration d'acide HF comprise entre 0.1% et 1%.

Ainsi, la présente invention apporte une amélioration déterminante à l'état de la technique antérieure en proposant un procédé de gravure sélective d'un masque 8 sur un substrat silicié 100 après implantation de dopants, qui est efficace, rapide et précis. Il en résulte la conservation précise des zones dopées 3 d'une seconde portion 2 du substrat silicié 100 de sorte que les dispositifs formés à partir de celui-ci sont fiables et présentent une performance améliorée.

## Revendications

1. Procédé de gravure sélective d'un masque (8) en matériau carboné disposé sur un substrat silicié (100), ce procédé comprenant les étapes consistant à :
a) Fournir un substrat silicié (100) comportant une première portion (1) recouverte par le masque (8) en matériau carboné et une seconde portion (2) dopée, le masque (8) comportant en surface une couche de surface (9) comprenant des espèces ioniques implantées et une couche sous-jacente (11) libre d'espèces ioniques implantées,
b) Exposer la couche de surface (9) et la seconde portion (2) à un plasma de SiCl₄ et de Cl₂ de sorte à déposer une couche de chlorure de silicium (12) SiClx sur la seconde portion (2) et à graver la couche de surface (9),
c) Graver la couche sous-jacente (11) de sorte à exposer la première portion (1), et
d) Graver la couche de chlorure de silicium (12) SiClx de sorte à exposer la seconde portion (2).

2. Procédé de gravure sélective selon la revendication 1, dans lequel le masque (8) en matériau carboné est constitué d'une résine carbonée, telle qu'une résine époxy, ou de Spin on Carbon (SoC) et dans lequel le substrat silicié (100) est constitué de silicium, de nitrure de silicium, d'oxyde de silicium, de SiC, de SiGe ou tout autre matériau comportant du silicium.

3. Procédé de gravure sélective selon l'une des revendications 1 à 2, dans lequel l'étape b) consiste à graver partiellement la couche de surface (9) et dans lequel l'étape b) comprend en outre une étape b1) consistant à graver par plasma fluoré la portion de la couche de surface (9) résiduelle, et notamment par plasma de CF₄ ou de SF₆.

4. Procédé de gravure sélective selon la revendication 3, dans lequel le plasma fluoré de l'étape b1) comprend en outre de l'oxygène.

5. Procédé de gravure sélective selon l'une des revendications 1 à 4, dans lequel le plasma utilisé à l'étape b) est obtenu par un débit de SiCl₄ compris entre 20 à 200 cm³/min et un débit de Cl₂ inférieur à 20 cm³/min.

6. Procédé de gravure sélective selon l'une des revendications 1 à 5, dans lequel le plasma utilisé à l'étape b) est obtenu dans un réacteur de gravure paramétré pour fournir une puissance inférieure à 300 W.

7. Procédé de gravure sélective selon l'une des revendications 1 à 6, dans lequel l'étape b) est réalisée dans un réacteur de gravure paramétré pour appliquer au substrat silicié (100) une tension de polarisation comprise entre 100V et 200V et de préférence une tension de polarisation comprise entre 120V et 150V.

8. Procédé de gravure sélective selon la revendication 7, dans lequel l'étape b) utilise une tension de polarisation pulsée, avec une fréquence notamment comprise entre 100Hz et 5kHz et un rapport cyclique compris entre 20 et 90%.

9. Procédé de gravure sélective selon la revendication 1 à 8, dans lequel l'étape c) est réalisée par plasma d'un mélange d'azote et d'hydrogène, notamment par plasma généré avec une fréquence choisie parmi les micro-ondes.

10. Procédé de gravure sélective selon l'une des revendications 1 à 8, dans lequel les étapes b), c) et/ou b1) sont réalisées dans la même enceinte d'un réacteur de gravure, le réacteur de gravure plasma étant du type réacteur de gravure plasma à couplage capacitif ou à couplage inductif.

11. Procédé de gravure sélective selon l'une des revendications 1 à 10, dans lequel l'étape d) est réalisée par voie humide, notamment avec une solution diluée d'HF.

12. Procédé de gravure sélective selon l'une des revendications 1 à 11, dans lequel l'étape a) comprend au préalable une étape a1) consistant à former le masque (8) sur la première portion (1) du substrat silicié (100) puis une étape a2) consistant à implanter des espèces ioniques dans la seconde portion (2) du substrat silicié (100) et dans le masque (8) de sorte à former la couche de surface (9).

## Patentansprüche

1. Verfahren zur selektiven Gravur einer Maske (8) aus kohlenstoffhaltigem Material, die auf einem siliciumhaltigen Substrat (100) angeordnet ist, wobei das Verfahren die Schritte umfasst, die aus Folgendem bestehen:
a) Liefern eines siliciumhaltigen Substrats (100), umfassend einen ersten Abschnitt (1), der mit der Maske (8) aus kohlenstoffhaltigem Material bedeckt ist, und einen zweiten dotierten Abschnitt (2), wobei die Maske (8) auf der Oberfläche eine Oberflächenschicht (9) umfasst, umfassend implantierte ionische Spezies und eine darunter liegende Schicht (11), die frei von implantierten ionischen Spezies ist,
b) Aussetzen der Oberflächenschicht (9) und des zweiten Abschnitts (2) an ein Plasma aus SiCl₄ und Cl₂, um eine Schicht aus Siliciumchlorid (12) SiClx auf dem zweiten Abschnitt (2) abzulegen und die Oberflächenschicht (9) zu gravieren,
c) Gravieren der darunter liegenden Schicht (11), um den ersten Abschnitt (1) auszusetzen, und
d) Gravieren der Schicht aus Siliciumchlorid (12) SiClx, um den zweiten Abschnitt (2) auszusetzen.

2. Verfahren zur selektiven Gravur nach Anspruch 1, wobei die Maske (8) aus kohlenstoffhaltigem Material aus einem kohlenstoffhaltigem Harz besteht, wie z. B. einem Epoxyharz, oder von Spin on Carbon (SoC), und wobei das siliciumhaltige Substrat (100) aus Silicium, Siliciumnitrid, Siliciumoxid, SiC, SiGe oder jedem anderen Material, das Silicium umfasst, besteht.

3. Verfahren zur selektiven Gravur nach einem der Ansprüche 1 bis 2, wobei der Schritt b) darin besteht, die Oberflächenschicht (9) teilweise zu gravieren, und wobei der Schritt b) außerdem einen Schritt b1) umfasst, der darin besteht, durch fluorhaltiges Plasma den Restabschnitt der Oberflächenschicht (9) und insbesondere durch Plasma aus CF₄ oder SF₆ zu gravieren.

4. Verfahren zur selektiven Gravur nach Anspruch 3, wobei das fluorhaltige Plasma von Schritt b1) außerdem Sauerstoff umfasst.

5. Verfahren zur selektiven Gravur nach einem der Ansprüche 1 bis 4, wobei das Plasma, verwendet in Schritt b), durch einen Durchsatz von SiCl₄, der zwischen 20 und 200 cm³/min liegt, und einen Durchsatz von Cl₂ von weniger als 20 cm³/min erhalten wird.

6. Verfahren zur selektiven Gravur nach einem der Ansprüche 1 bis 5, wobei das Plasma, verwendet in Schritt b), in einem Gravurreaktor erhalten wird, der parametriert ist, um eine Leistung von weniger als 300 W zu liefern.

7. Verfahren zur selektiven Gravur nach einem der Ansprüche 1 bis 6, wobei der Schritt b) in einem Gravurreaktor durchgeführt wird, der parametriert ist, um auf das siliziumhaltige Substrat (100) eine Polarisierungsspannung anzulegen, die zwischen 100 V und 200 V liegt, und vorzugsweise eine Polarisierungsspannung, die zwischen 120 V und 150 V liegt.

8. Verfahren zur selektiven Gravur nach Anspruch 7, wobei Schritt b) eine gepulste Polarisierungsspannung mit einer Frequenz verwendet, die insbesondere zwischen 100 Hz und 5 kHz liegt, und ein Tastverhältnis, das zwischen 20 und 90 % liegt.

9. Verfahren zur selektiven Gravur nach Anspruch 1 bis 8, wobei der Schritt c) durch Plasma einer Mischung aus Stickstoff und Wasserstoff durchgeführt wird, insbesondere durch Plasma, das mit einer Frequenz erzeugt wird, die aus den Mikrowellen ausgewählt ist.

10. Verfahren zur selektiven Gravur nach einem der Ansprüche 1 bis 8, wobei die Schritte b), c) und/oder b1) im gleichen Behälter eines Gravurreaktors durchgeführt werden, wobei der Plasmagravurreaktor vom Typ Plasmagravurreaktor mit kapazitiver Kopplung oder mit induktiver Kopplung ist.

11. Verfahren zur selektiven Gravur nach einem der Ansprüche 1 bis 10, wobei der Schritt d) auf feuchtem Weg durchgeführt wird, insbesondere mit einer verdünnten Lösung von HF.

12. Verfahren zur selektiven Gravur nach einem der Ansprüche 1 bis 11, wobei der Schritt a) zunächst einen Schritt a1) umfasst, der darin besteht, die Maske (8) auf dem ersten Abschnitt (1) des siliziumhaltigen Substrats (100) zu bilden, dann einen Schritt a2), der darin besteht, ionische Spezies im zweiten Abschnitt (2) des siliziumhaltigen Substrats (100) und in der Maske (8) zu implantieren, um die Oberflächenschicht (9) zu bilden.

## Claims

1. A selective etching process of a carbon material mask (8) disposed on a silicon substrate (100), this process comprising the steps consisting in:
a) Providing a silicon substrate (100) including a first portion (1) covered by the carbon material mask (8) and a second doped portion (2), the mask (8) including at its surface a surface layer (9) comprising implanted ionic species and an underlying layer (11) free of implanted ionic species
b) Exposing the surface layer (9) and the second portion (2) to a SiCl₄ and Cl₂ plasma so as to deposit a silicon chloride SiClₓ layer (12) on the second portion (2) and to etch the surface layer (9),
c) Etching the underlying layer (11) so as to expose the first portion (1), and
d) Etching the silicon chloride SiClₓ layer (12) so as to expose the second portion (2).

2. The selective etching process according to claim 1, wherein the carbon material mask (8) consists of a carbon resin, such as epoxy resin, or Spin on Carbon (SoC) and in which the silicon substrate (100) consists of silicon, silicon nitride, silicon oxide, SiC, SiGe or any other material including silicon.

3. The selective etching process according to any of claims 1 to 2, wherein step b) consists in partially etching the surface layer (9) and in which step b) further comprises a step b1) consisting in etching by fluorine plasma the portion of the residual surface layer (9), and in particular by CF₄ or SF₆ plasma.

4. The selective etching process according to claim 3, wherein the fluorine plasma of step b1) further comprises oxygen.

5. The selective etching process according to any of claims 1 to 4, wherein the plasma used in step b) is obtained by a SiCl₄ flow rate comprised between 20 and 200 cm³/min and a Cl₂ flow rate lower than 20 cm³/min.

6. The selective etching process according to any of claims 1 to 5, wherein the plasma used in step b) is obtained in an etching reactor configured to provide a power lower than 300 W.

7. The selective etching process according to any of claims 1 to 6, wherein step b) is carried out in an etching reactor configured to apply to the silicon substrate (100) a bias voltage comprised between 100 V and 200 V and preferably a bias voltage comprised between 120 V and 150 V.

8. The selective etching process according to claim 7, wherein step b) uses a pulsed bias voltage, with a frequency particularly comprised between 100 Hz and 5 kHz and a duty cycle comprised between 20 and 90%.

9. The selective etching process according to claim 1 to 8, wherein step c) is carried out by a mixture of nitrogen and hydrogen plasma, in particular by plasma generated with a frequency selected from the microwaves.

10. The selective etching process according to any of claims 1 to 8, wherein steps b), c) and/or b1) are carried out in the same enclosure of an etching reactor, the plasma etching reactor being an etching reactor of the capacitively or inductively coupled plasma type.

11. The selective etching process according to any of claims 1 to 10, wherein step d) is carried out by wet method, in particular with a HF dilute solution.

12. The selective etching process according to any of claims 1 to 11, wherein step a) comprises beforehand a step a1) consisting in forming the mask (8) on the first portion (1) of the silicon substrate (100) then a step a2) consisting in implanting ionic species in the second portion (2) of the silicon substrate (100) and in the mask (8) so as to form the surface layer (9).
